# EUROPEAN PATENT APPLICATION

(11) **EP 2 626 899 A2**
(43) Date of publication of application: **14.08.2013**
(21) Application number: 13154648.3
(22) Date of filing: 08.02.2013
(51) Int. Cl.: H01L 23/473

(54) **Heat dissipating module**

(30) Priority: 13.02.2012 US 201261597844 P
(71) Applicant: ASUSTeK Computer Inc., Peitou, Taipei (TW)
(72) Inventor: Chen, Meng-Ping, Taipei (TW); Ho, Ching, Taipei (TW)
(74) Representative: Zimmermann, Tankred Klaus

(57) **Abstract**

A heat dissipating module includes a base, at least one thermal conductive element, at least one liquid-pipe and a heat sink. The thermal conductive element is disposed at the base. The liquid-pipe is disposed adjacent to the thermal conductive element. The liquid-pipe is disposed at the base. The heat sink covers the thermal conductive element and the liquid-pipe. A part of the heat sink is connected to the base. The heat sink includes a plurality of fins. The heat dissipating module combines air-cooling with liquid-cooling so as to enhance thermal conductivity.

## Description

### BACKGROUND OF THE INVENTION

### 1. Field of the Invention

The invention relates to a heat dissipating module and, more particularly, to a heat dissipating module combining air-cooling and liquid-cooling.

### 2. Description of Related Art

As execution efficiency and functions of a computer are improved and processing speed enhances, the central processing unit (CPU) or other electronic elements at a motherboard generates more heat due to high frequency oscillation and electromagnetic effect after a long time usage. If the heat is not dissipated instantly, the electronic elements may be damaged or affected.

Conventionally, a heat dissipater is disposed at a heat source to conduct the heat from the heat source to fins of the heat dissipater, and then cool air is blown to the fins of the heat dissipater and the heat is brought out via a fan and air circulation. The heat dissipater includes a base connecting to the electronic elements and a plurality of the fins disposed at the base. The base is usually a smooth metal plate which can conduct heat. The base contacts with the surface of the electronic elements to absorb the heat from the electronic elements, and the heat is conducted to the fins for dissipating. However, the heat dissipater is limited by the inner height and the weight of the system. Furthermore, when it is applied to a CPU with a high wattage (such as 130W or more), a fan with higher rotating speed is needed, the noise is too loud and the heat dissipating efficiency is poor.

Furthermore, a water-cooling method cooperating with a pump for circulating hot and cold water is also used to dissipate heat. However, in a high-level system or electronic device, the heat dissipating effect of air-cooling or liquid cooling is limited due to the device size and the using circumstance.

### SUMMARY OF THE INVENTION

A heat dissipating device applied to an electronic device is disclosed. The heat dissipating device simplifies elements in a conventional heat dissipating module, and combines air-cooling with liquid cooling in a limited space to improve the whole heat dissipating efficiency and maintain the working performance of the electronic device effectively.

A heat dissipating module includes a base, at least a thermal conductive element, at least a liquid-pipe and a heat sink. The thermal conductive element is disposed at the base. The liquid-pipe is adjacent to the thermal conductive element and is disposed at the base. The heat sink covers the thermal conductive element and the liquid-pipe. At least a part of the heat sink is connected to the base. The heat sink includes a plurality of fins. The heat dissipating module is disposed at a circuit board.

A heat dissipating module includes a base, at least a thermal conductive element, a heat sink and at least a liquid-pipe. The thermal conductive element is disposed at the base. The heat sink covers the thermal conductive element and at least a part of the heat sink is connected to the base. The heat sink includes a plurality of fins. The fins include at least a recess, respectively. The liquid-pipe is disposed in the recess of the fins. Two sides of the heat sink cover the thermal conductive element and the liquid-pipe, respectively.

The heat dissipating module includes the thermal conductive element and the liquid-pipe in a limited space instead of including only the air-cooling device or the water-cooling device to increase heat dissipating speed greatly. Moreover, the heat dissipating module has more heat dissipating paths, which further improves heat dissipating efficiency.

These and other features, aspects and advantages of the present invention will become better understood with regard to the following description, appended claims, and accompanying drawings.

### BRIEF DESCRIPTION OF THE DRAWINGS

FIG. 1A is an exploded diagram showing a heat dissipating module in a first embodiment;

FIG. 1B is an schematic diagram showing the assembled heat dissipating module in FIG. 1A;

FIG. 1C is a sectional schematic diagram showing the heat dissipating module in FIG. 1B;

FIG. 2 is a sectional schematic diagram showing a heat dissipating module in a second embodiment;

FIG. 3A is a schematic diagram showing an electronic device applying a heat dissipating module in an embodiment;;

FIG. 3B is an exploded diagram showing an electronic device applying a heat dissipating module in an embodiment;

FIG. 4A is an exploded diagram showing a heat dissipating module in a third embodiment;

FIG. 4B is a schematic diagram showing the assembled heat dissipating module in FIG. 4A;

FIG. 5A is an exploded diagram showing a heat dissipating module in a fourth embodiment; and

FIG. 5B is a schematic diagram showing the assembled heat dissipating module in FIG. 5A.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

A heat dissipating module is illustrated with relating figures, and the same symbols denote the same components.

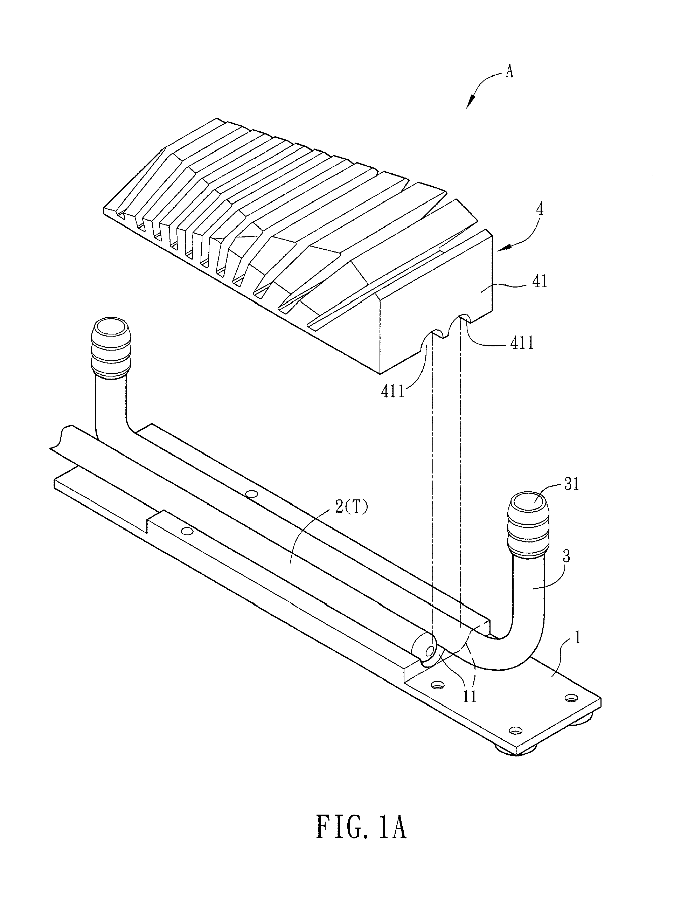

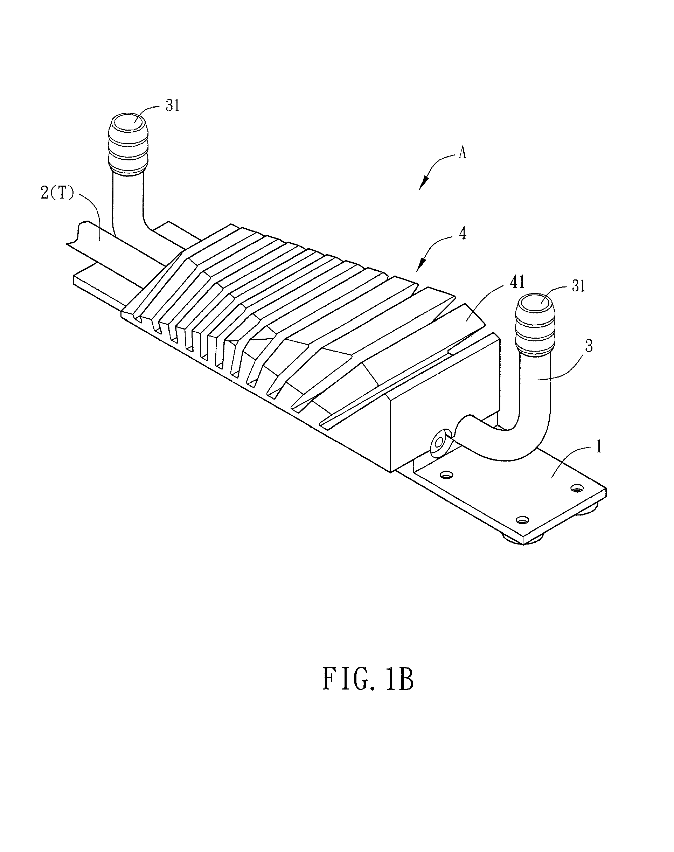

FIG. 1A is an exploded diagram showing a heat dissipating module in a first embodiment, and FIG. 1B is an schematic diagram showing the assembled heat dissipating module in FIG. 1A. Please refer to FIG. 1A and FIG. 1B, the heat dissipating module A includes a base 1, at least a thermal conductive element T. In the embodiment, the thermal conductive element includes a heat pipe 2, at least a liquid-pipe 3 and a heat sink 4. The heat pipe 2 including the thermal conductive element T is taken as an example. The heat dissipating module A is disposed at a circuit board or other heat sources (such as an electronic element) via the base 1. The structure and components of the heat dissipating module A are illustrated first, and practical usage of the heat dissipating module A with the electronic device would be described later.

As shown in FIG. 1A and FIG. 1B, the heat pipe 2 and the liquid-pipe 3 are adjacently disposed at a same surface of the base 1. The base 1 may be made of high thermal conductive material, such as copper, silver, aluminum or alloy, which is not limited herein. The bottom of the base 1 contacts with a heat source of the electronic device, such as a CPU, a chipset or a passive element.

The heat from the heat source of the electronic device is conducted via the base 1, and the base 1 may accommodate the heat pipe 2 and the liquid-pipe 3 to increase contacting area therebetween, so that the heat can be conducted and dissipated evenly and rapidly via the heat pipe 2 and the liquid-pipe 3.

The base 1 includes two recesses 11, and the two recesses 11 contact with and accommodate the heat pipe 2 and the liquid-pipe 3, respectively. The two recesses 11 are disposed at a same side of the base 1, and the heat pipe 2 and the liquid-pipe 3 are disposed in the two recesses 11 of the base 1, respectively. The side for the recesses 11 is opposite to that of the heat source. The recesses 11 of the base 1 accommodate a part of the heat pipe 2 and the liquid-pipe 3, fix them in the base 1, and increase the contacting area therebetween, so as to improve the heat conducting efficiency.

In the embodiment, the heat pipe 2 is a long, thin, hollow metal pipe with two closed ends. The shape and size of the heat pipe 2 are not limited and determined by the circumstance, disposing space, heat conduction and temperature or others. An inner wall of the heat pipe 2 includes wick structures which have liquid inside, and the liquid is called working medium of the heat pipe.

The liquid-pipe 3 is also a hollow pipe and has a smooth inner wall. In the embodiment, the liquid-pipe 3 may also include wick structures to improve water-cooling effect, which is not limited herein. Other pipes which have cooling liquid flowing inside are also within the scope.

The heat pipe 2 and the liquid-pipe 3 may be welded onto the base 1. Solder, a tin bar or solder paste may be put in the recesses 11 of the base 1 first, and then the heat pipe 2 and the liquid-pipe 3 are put into the recesses 11 of the base 1 for welding, which is not limited herein. The heat pipe and the liquid-pipe also may be fixed to the base in other methods.

In the embodiment, two ends of the liquid-pipe 3 include a joint 31, respectively. The joint 31 may be welded to the ends of the liquid-pipe 3, and the liquid-pipe 3 can be connected to a water-cooling element (such as a water tank or a pump) via the joint 31. The liquid-pipe is integratedly formed along three directions of an x-y-z coordinate. The joint 31 may also be fixed at the ends of the liquid-pipe 3 by inserting or locking, which is not limited herein.

The heat sink 4 covers the heat pipe 2 and the liquid-pipe 3. The heat sink 4 includes a plurality of fins 41. The fins 41 include at least two recesses 411, respectively. The recesses 411 of the fins 41 cover and contact with the heat pipe 2 and the liquid-pipe 3, respectively. The recesses 411 of the fins 41 accommodate a part of the heat pipe 2 and the liquid-pipe 3 to increase the contacting area therebetween and improve the heat conducting efficiency, which is the same as the recesses 11 of the base 1. The fins 41 may be made by aluminum extrusion or aluminum die-casting, which is not limited herein.

In FIG. 1A and FIG. 1B, the fins 41 are arranged at intervals obliquely to form the heat sink 4, but the number, the size and arrangement of the fins 41 are not limited. The fins 41 may be also arranged at intervals horizontally or vertically to form the heat sink according to the structure of the electronic device, layout of other elements and the whole heat dissipating requirements.

In the embodiment, at least a part of the heat sink 4 is connected to the base 1, and it may be welded onto the heat pipe 2, the liquid-pipe 3 and the base 1. The heat sink 4 may also be disposed at the heat pipe 2, the liquid-pipe 3 and the base 1 via inserting, locking, fixing or pasting, which is not limited herein.

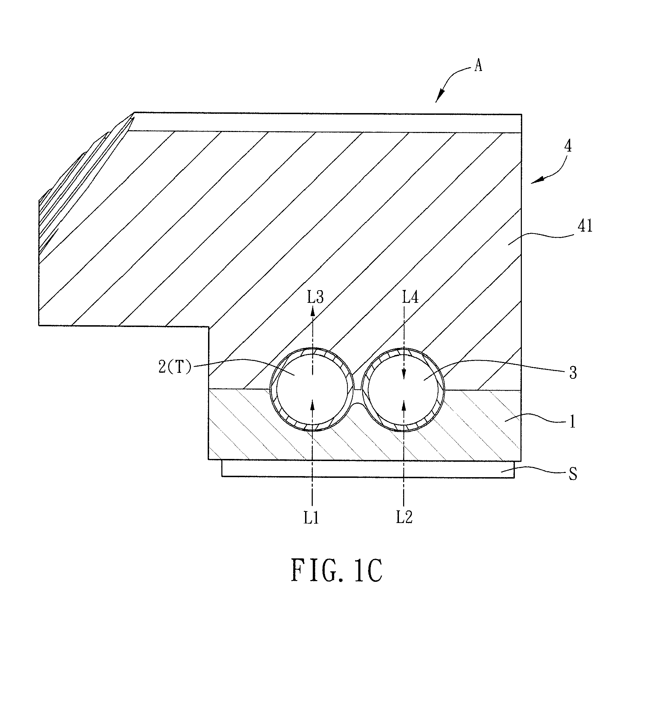

FIG. 1C is a sectional schematic diagram showing the heat dissipating module in FIG. 1B. The heat dissipating module A with a heat source S is used to illustrate the heat conducting path. In the embodiment, the heat pipe 2 does not contact with the liquid-pipe 3. The heat source S (such as a CPU) gives out heat. When the base 1 contacts with the heat source S at a higher temperature, the heat conducting starts. After the heat is conducted from the heat source S to the base 1, it is conducted to the heat pipe 2 and the liquid-pipe 3.

As stated above, the heat is conducted to the heat pipe 2 via a path L1, and transferred to the liquid-pipe 3 via a path L2 at the same time. After the heat is conducted to the heat pipe 2 via the path L1, it can be further conducted to the fins 41 via a path L3, and it is dissipated via other heat dissipaters (such as a fan). The heat conducted to the fins 41 can not only be dissipated via air-cooling, but also conducted to the liquid-pipe 3 via a path L4 in a water-cooling manner.

The heat conducting medium for heat transferring through can be reduced via the structure that the heat pipe 2 adjacent to the liquid-pipe 3, and the heat dissipating paths are increased to improve the heat dissipating efficiency. Moreover, the size of the heat dissipating module can be reduced, and thus the space in the electronic device for disposing the heat dissipating module is saved.

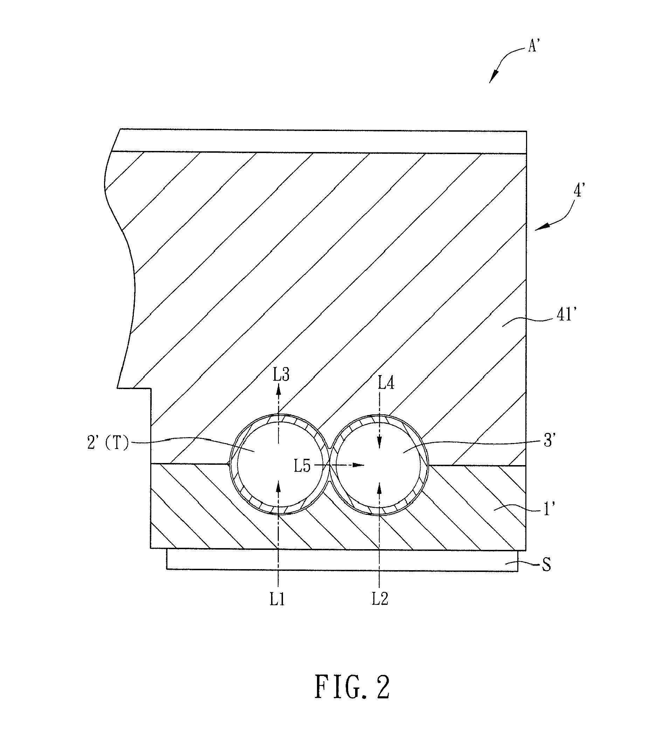

FIG. 2 is a sectional schematic diagram showing a heat dissipating module in a second embodiment. In the embodiment, the heat dissipating module A' has similar structures and features with that of the heat dissipating module A, and the difference is that the heat pipe 2' disposed at the base 1' contacts with the liquid-pipe 3'. The heat conducting paths from the heat source S to the heat dissipating module A' are similar to the paths in the above embodiment, and they further include a path L5. Moreover, the heat pipe 2' is taken as an example of the thermal conductive element T in the embodiment.

Since the heat pipe 2' contacts with the liquid-pipe 3', the heat can be conducted from the heat pipe 2' to the liquid-pipe 3' via the path L5 directly, and it does not need to be conducted from the fins 41' of the heat sink 4' to the liquid-pipe 3' via the path L3 and the path L4. Thus, the heat passes through less conducting medium and the heat dissipating path is further shortened, which improves the whole heat dissipating efficiency.

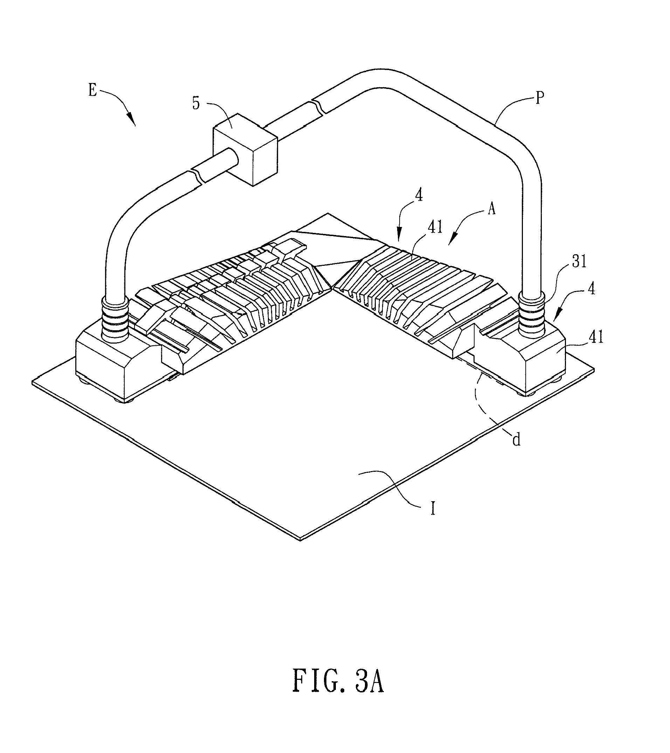

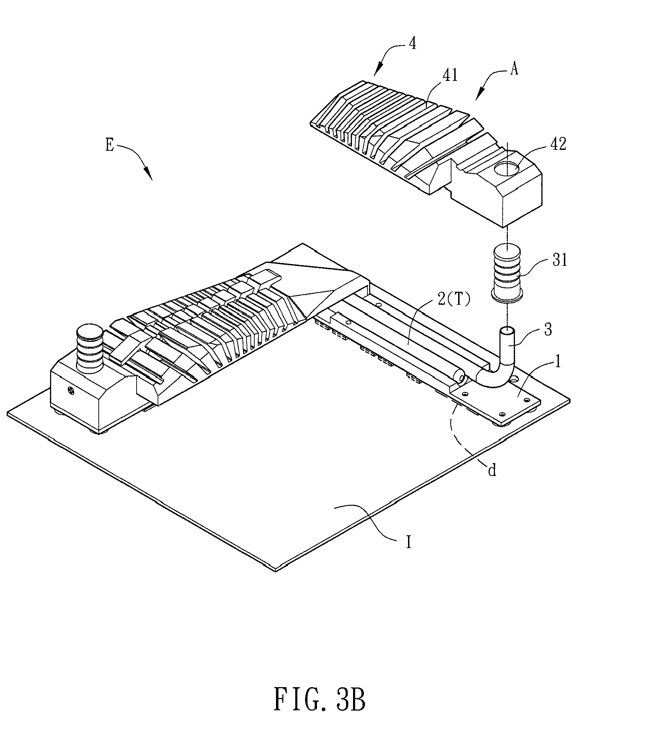

FIG. 3A is a schematic diagram showing an electronic device applying a heat dissipating module in an embodiment, and FIG. 3B is an exploded diagram showing an electronic device applying a heat dissipating module in an embodiment.

As shown in FIG. 3A and FIG. 3B, the electronic device E at least includes a circuit board I and at least a heat dissipating module A. The heat dissipating module A has a similar structure and features with that of the heat dissipating module in the above embodiment, which is omitted herein. The heat dissipating module A is disposed at the electronic elements d at the circuit board I, and contacts with the electronic elements d. In the embodiment, the electronic device E may be a motherboard or an electronic device which includes heat sources, which is not limited herein. Since the electronic elements d give out heat in operation, the heat dissipating module A dissipates the heat from the electronic elements d to maintain normal operation temperature.

In the embodiment, the heat dissipating module A further includes a liquid cooling set 5. The liquid cooling set 5 is connected to the joint 31 of the liquid-pipe 3 via a pipe P. The liquid cooling set 5 includes a liquid container (such as a water tank) and a pump. The liquid-pipe 3 is connected to the liquid cooling set 5, and drives the liquid inside to flow via the pump in the liquid cooling set 5, so as to form a water-cooling circulation mechanism.

In the embodiment, the liquid-pipe 3 is connected to the liquid cooling set 5 via the joint 31 and the pipe P. Furthermore, an end of the heat sink 4 has a hole 42. The joint 31 and the hole 42 can fix the heat sink 4 on the heat pipe 2 and the liquid-pipe 3 via locking, so as to increase the contacting area between the fins 41, the heat pipe 2 and the liquid-pipe 3 to improve the heat dissipating effect. The joint 31 may be combined with the hole 42 via inserting or locking to fix the liquid-pipe and the fins, and the joint 31 may be a quick-release joint, which is not limited herein.

The heat dissipating module A is directly disposed at the electronic elements d, and connected to the electronic elements d via the base 1. The connecting method may be locking, inserting or welding, which is not limited herein. The size, the number of the heat pipe 2 and the liquid-pipe 3, and the connection therebetween are determined by heat dissipating requirements and the structure of the electronic device. The electronic device may further include other heat dissipating elements, such as a fan.

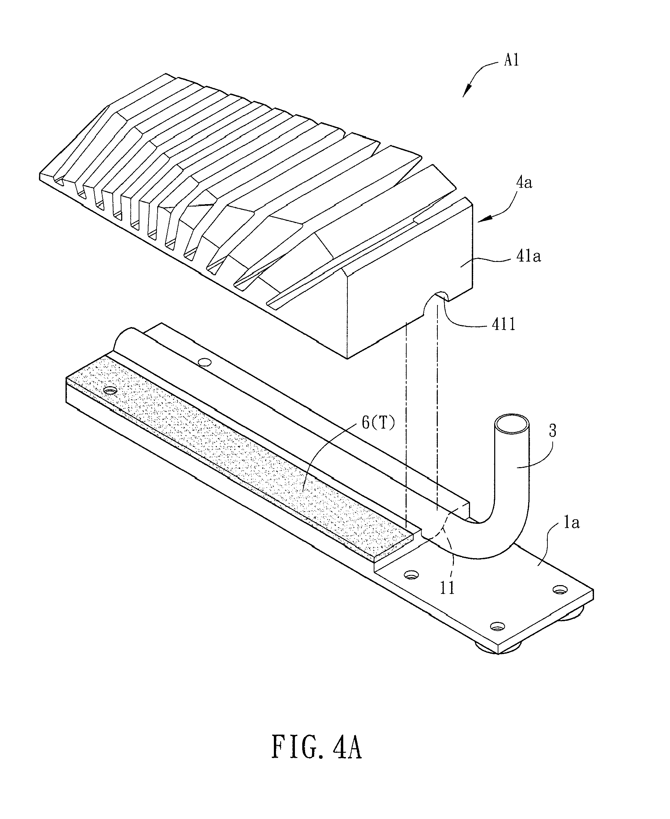

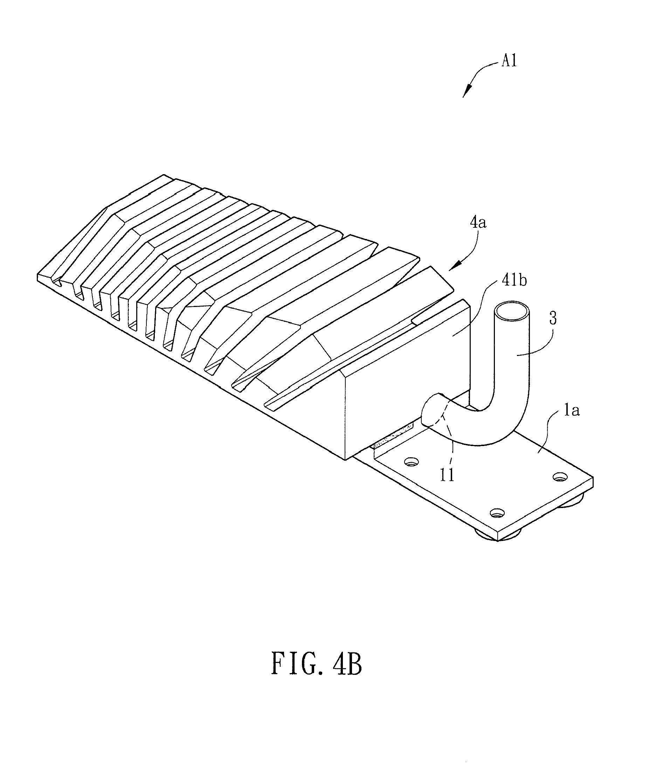

FIG. 4A is an exploded diagram showing a heat dissipating module in a third embodiment, and FIG. 4B is a schematic diagram showing the assembled heat dissipating module in FIG. 4A. As shown in FIG. 4A and FIG. 4B, in the embodiment, the heat dissipating module A1 has a similar structure and features with that of the heat dissipating module A in the above embodiment. The difference is that the thermal conductive element includes a thermal conductive sheet 6. The thermal conductive sheet 6 is taken as an example of the thermal conductive element T. The thermal conductive sheet 6 is adjacent to the liquid-pipe 3 and disposed at the base 1a. The heat sink 4a includes a recess 411 and the base 1a includes a recess 11, and the recesses contact with and accommodate the liquid-pipe 3. The heat from the base 1a can be conducted to the fins 41a more evenly via the thermal conductive sheet 6, so as to improve the heat dissipating effect.

The thermal conductive sheet 6 may be a rectangular sheet made of heat conductive material (such as metal or alloy), and its size can be adjusted according to the heat dissipating requirements. The thermal conductive sheet 6 may be integratedly formed with the base 1a, which is not limited herein, and thus the heat passes through less medium and the heat dissipating efficiency is improved.

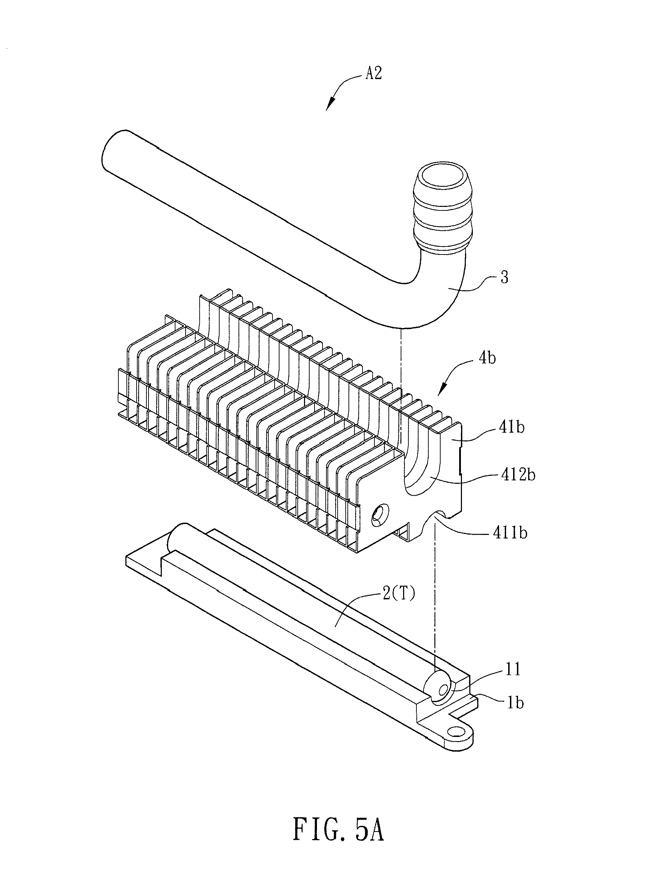

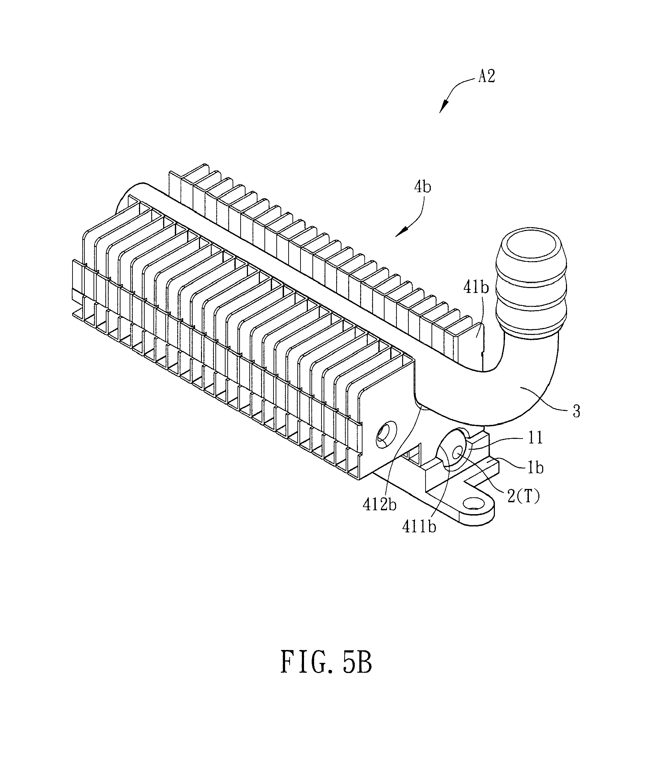

FIG. 5A is an exploded diagram showing a heat dissipating module in a fourth embodiment, and FIG. 5B is a schematic diagram showing the assembled heat dissipating module in FIG. 5A. In the embodiment shown in FIG. 5A and FIG. 5B, the heat dissipating module A2 includes similar elements with those of the heat dissipating module A in the above embodiment. The difference is that the base 1b includes at least a recess 11 which contacts with and accommodates the thermal conductive element T. In the embodiment, the thermal conductive element T is the heat pipe 2, and the disposing side of the recess 11 is opposite to that of the heat source. The heat sink 4b is disposed on the heat pipe 2 and covers the heat pipe 2. The heat sink 4b includes at least two recesses 411 band 412b. The recesses 411 band 412b are disposed at two opposite sides of the heat sink 4b. The recess 411b is disposed at a first surface of the fins near the heat pipe 2, and the heat sink 4b at least accommodates a part of the heat pipe 2 via the recesses 411b. The recess 412b disposed at a second surface of the heat sink 4b accommodates the liquid-pipe 3, and the heat pipe 2 and the liquid-pipe 3 contact with the fins 41b. Thus, the contacting area between the heat pipe 2 and the fins 41b, between the liquid-pipe 3 and the fins 41b is increased, and the heat conducting efficiency therebetween is improved.

In the embodiment, the connections between the base 1b and the heat pipe 2, the heat pipe 2 and the heat sink 4b, the heat sink 4b and the liquid-pipe 3 may be via welding, pasting or screw locking, which is not limited herein.

In sum, the heat dissipating module applied to the electronic device combines the air-cooling and the water-cooling. The heat dissipating module conducts heat from the heat source (such as an electronic element) to a side opposite to that of the heat source evenly via the thermal conductive sheet, the heat is further conducted to the fins along the path of the heat pipe via the structure of the heat pipe and the liquid-pipe, and a heat dissipater (such as a fan) also may be used to dissipate the heat in cooperation. The heat dissipating module also includes multiple heat conducting paths including a path from the base to the liquid-pipe, a path from the heat pipe to the fins, and a path from the fins to the liquid-pipe. After the heat is conducted to the liquid-pipe, the liquid absorbing the heat inside flows to form a circulation and takes the heat away.

Although the present invention has been described in considerable detail with reference to certain preferred embodiments thereof, the disclosure is not for limiting the scope of the invention. Persons having ordinary skill in the art may make various modifications and changes without departing from the scope of the invention. Therefore, the scope of the appended claims should not be limited to the description of the preferred embodiments described above.

## Claims

1. A heat dissipating module (A) disposed at a circuit board (I), **characterized by** comprising:
a base(1);
at least a thermal conductive element (T) disposed at the base (1);
at least a liquid-pipe (3) adjacent to the thermal conductive element (T) and disposed at the base (1); and
a heat sink (4) covering the thermal conductive element (T) and the liquid-pipe (3), wherein at least a part of the heat sink (4) is connected to the base (1), and the heat sink (4) includes a plurality of fins (41).

2. The heat dissipating module (A) according to claim 1, **characterized in that** two ends of the liquid-pipe (3) have a joint (31), respectively.

3. The heat dissipating module (A) according to claim 1, **characterized in that** the thermal conductive element (T) includes a heat pipe (2) or a thermal conductive sheet (6).

4. The heat dissipating module (A) according to claim 1, **characterized in that** the base (1) includes at least two recesses (11), the recesses (11) contact with and accommodate the thermal conductive element (T) and the liquid-pipe (3), respectively, and the recesses (11) are disposed at a same surface with the base (1).

5. The heat dissipating module (A) according to claim 1, **characterized in that** the heat dissipating module (A) further includes:
a liquid cooling set (5) connected to the liquid-pipe (3).

6. The heat dissipating module (A) according to claim 1, **characterized in that** the fins (41) includes at least two recesses (411), and the recesses (411) contact with the thermal conductive element (T) and the liquid-pipe (3), respectively.

7. The heat dissipating module (A) according to claim 1, **characterized in that** the liquid-pipe (3) is integratedly formed along three directions of an x-y-z coordinate.

8. A heat dissipating module (A) disposed at a circuit board (I), **characterized by** comprising:
a base (1);
at least a thermal conductive element (T) disposed at the base (1);
a heat sink (4) covering the thermal conductive element (T), wherein at least a part of the heat sink (4) is connected to the base (1), the heat sink (4) includes a plurality of fins (41), and the fins (41) includes multiple recesses (411), respectively; and
at least a liquid-pipe (3) disposed in the recesses (411) of the fins (41),
wherein the recesses (411) of the heat sink (4) cover the thermal conductive element (T) and the liquid-pipe (3).

9. The heat dissipating module (A) according to claim 8, **characterized in that** two ends of the liquid-pipe (3) have a joint (31), respectively.

10. The heat dissipating module (A) according to claim 8, **characterized in that** the thermal conductive element (T) includes a heat pipe (2) or a thermal conductive sheet (6).

11. The heat dissipating module (A) according to claim 8, **characterized in that** the base (1) includes at least a recess 11, and the recess 11 contacts with and accommodates the thermal conductive element (T).

12. The heat dissipating module (A) according to claim 8, **characterized in that** the heat dissipating module (A) further includes:
a liquid cooling set (5) connected to the liquid-pipe (3).

13. The heat dissipating module (A) according to claim 8, **characterized in that** the recess 411 of the heat sink (4) contacts with the liquid-pipe (3).

14. The heat dissipating module (A) according to claim 8, **characterized in that** the liquid-pipe (3) is integratedly formed along three directions of an x-y-z coordinate.
